# EUROPÄISCHE PATENTSCHRIFT

(11) **EP 2 507 608 B1**
(45) Veröffentlichungstag und Bekanntmachung des Hinweises auf die Patenterteilung: **01.05.2019**
(21) Anmeldenummer: 10775730.4
(22) Anmeldetag: 07.10.2010
(51) Int. Cl.: H05K 7/02, H05K 13/00, G01L 19/14

(54) **SENSOR MIT EINEM SENSORGEHÄUSE**
SENSOR HAVING A SENSOR HOUSING
CAPTEUR MUNI D'UN BOÎTIER

(30) Priorität: 04.12.2009 DE 102009047506
(43) Veröffentlichungstag der Anmeldung: 10.10.2012
(73) Patentinhaber: Robert Bosch GmbH, 70442 Stuttgart (DE)
(72) Erfinder: SCHOLZEN, Holger, 70374 Stuttgart (DE); GMELIN, Christoph, 70597 Stuttgart (DE); VOLLERT, Jens, 99974 Muehlhausen (DE); ELLMER, Markus, 99817 Eisenach (DE)
(86) Internationale Anmeldenummer: PCT/EP2010/065029
(87) Internationale Veröffentlichungsnummer: WO 2011/067022

(56) Entgegenhaltungen:
- WO-A1-03/100371
- WO-A1-03/100371
- DE-A1- 19 961 776
- DE-A1- 19 961 776
- JP-A- 11 326 087
- JP-A- H11 326 087
- US-A1- 2003 057 541
- US-A1- 2003 057 541

## Beschreibung

### Stand der Technik

DE 102 23 357 A1 bezieht sich auf eine Vorrichtung zur Druckmessung. Die Vorrichtung zur Druckmessung umfasst ein Gehäuse, in dem ein mit einem Sensorelement und mit elektrischen Anschlusselementen versehener Träger angeordnet ist. Das Gehäuse weist einen das Sensorelement umgebenden und in einem ersten Druckkanal eines ersten Druckanschlusses verbundenen ersten Gehäuseraum sowie einem gegenüber dem ersten Gehäuseraum abgedichteten, wenigstens die elektrischen Anschlusselemente umgebenden, zweiten Gehäuseraum auf. Das Gehäuse weist ein gegenüber dem ersten Gehäuseraum und dem zweiten Gehäuseraum abgedichteten dritten Gehäuseraum auf, der mit einem zweiten Druckkanal eines zweiten Druckanschlusses verbunden ist.

Bei heutigen Entwicklungen für Drucksensoren wird ein Aufbaukonzept verfolgt, was mit dem Begriff CiH (chip-in-Housing) bezeichnet wird. Gemäß diesem Aufbaukonzept werden die Sensorchips unmittelbar in das Sensorgehäuse aus Kunststoff eingeklebt. Werden zwei Chips, so zum Beispiel ein Sensorelement und ein von diesem getrennter Elektronikbaustein wie zum Beispiel ein ASIC eingesetzt, besteht das Erfordernis, mehrere elektrische Verbindungen zwischen Sensorelement und dem elektrischen Bauelement, wie zum Beispiel dem oben erwähnten ASIC zu schaffen. Um die Medienbelastung, der das elektronische Bauelement ausgesetzt ist, herabzusetzen und im Idealfall ganz zu vermeiden, sieht das Aufbaukonzept vor, das elektronische Bauelement und das Sensorelement in getrennten Kammern anzuordnen. Die Trennung zwischen beiden Kammern muss mediendicht gegenüber Abgas, Feuchtigkeit und anderen Medien ausgelegt sein. Gemäß heutiger Lösungen wird ein in das Gehäuse des Drucksensors eingespritztes Leadframe eingesetzt, auf welches von beiden Seiten geklebt, insbesondere gebondet wird. Diese Technik setzt eine dichte Umspritzung eines Leiterkamms, d. h. des Leadframes voraus, um ein Eindringen zum Beispiel von Feuchtigkeit zu vermeiden. Die erforderliche Mediendichtheit von Einlegeteilen ist jedoch in der Regel nicht gegeben. Zudem kann es aufgrund des Bondprozesses zu einem Angriff auf eine goldene oder vergoldete Oberfläche des Leiterkamms kommen, was die Ausbildung von Korrosionserscheinungen begünstigt. Gemäß heutiger Lösungen wird als zusätzlicher Schutz, die Kammer, in der das Sensorelement aufgenommen ist, mit einem Gel befüllt.

Bei aktuell in Serie befindlichen Sensoren, insbesondere Drucksensoren, die in Niedrigdruckbereichen eingesetzt werden, befinden sich das elektronische Bauelement ASIC und das Sensorelement auch innerhalb ein und desselben Gehäusebereiches, beziehungsweise innerhalb ein und derselben Kammer. Auch ist es üblich, dass das Sensorelement und das elektronische Bauelement, d. h. das ASIC, innerhalb ein- und desselben Silizium-Chips ausgebildet sind. Eine wesentliche Anforderung an neue Generationen von Sensoren, insbesondere von Drucksensoren, ist es, dass diese wesentlich abgasresistenter sein müssen, als vorangehende Sensorgenerationen. Es hat sich herausgestellt, dass die Abgasresistenz des Sensorelementes leichter zu gewährleisten ist als die Abgasresistenz des elektronischen Bauelementes, beispielsweise eines ASICs. Dies ist neben einem erforderlichen Variantenmanagement hinsichtlich flexibler Zusammenstellung kundenspezifischer Sensorelementausprägungen mit ebenfalls variablen ASIC Ausführungen der Grund dafür, dass das elektronische Bauelement, insbesondere ein ASIC und der Sensor voneinander zu trennen sind.

Das Sensorelement sitzt somit in einer Kammer, die dem Medium, insbesondere dem Abgas ausgesetzt ist, während sich das elektronische Bauelement, d. h. der ASIC in einer davon getrennten Kammer befindet, welche dem Medieneinfluss nicht ausgesetzt sein darf.

Für Niedrigdrucksensoren werden zwei Silizium-Chips eingesetzt. Einer der beiden Chips dient als Sensorelement während der andere als ein elektronisches Bauelement zum Beispiel ein ASIC dient.

Eine wesentliche Anforderung an diese neue Drucksensorentwicklung ist, dass diese wesentlich abgasresistenter sein muss, als vorherige Generationen von Drucksensoren. Es ist im Allgemeinen leichter, die Abgasresistenz eines Sensorelementes zu gewährleisten im Vergleich zum Gewährleisten der Abgasresistenz für ein elektronisches Bauelement wie eines ASICs. Dies ist neben dem erforderlichen Variantenmanagement unter Berücksichtigung von kundenspezifischen Sensorelementausprägungen aus ebenfalls variablen ASIC Ausführungen der Grund, ein Sensorelement und ein elektronisches Bauelement wie zum Beispiel einen ASIC voneinander zu trennen.

Die Dokumente DE 199 61776 A1, JP 11 326087 A und WO 03/1300371 A1 beschreiben aus dem Stand der Technik bekannte Drucksensoren mit einem Sensorgehäuse und einem Sensorelement.

### Darstellung der Erfindung

Der erfindungsgemäß vorgeschlagenen Lösung folgend, werden in eine Grundplatte eines Sensorgehäuses, das insbesondere aus Kunststoff hergestellt wird, ein elektronisches Bauelement, zum Beispiel ein ASIC oder ein Sensorelement aufgebracht. Das elektronische Bauelement sowie das Sensorelement werden bevorzugt auf eine obere, dem Medium ausgesetzte, Planseite der Grundplatte aufgeklebt. Etwa in der Mitte zwischen dem Sensorelement und dem von diesem beabstanded angeordneten elektronischen Bauelement, zum Beispiel einem ASIC, wird eine elektrische Verbindung so zum Beispiel eine Leiterbahn angeordnet. Diese elektrische Verbindung, die als Leiterbahn dient, wird vorzugsweise in MID-Technologie dargestellt und kann zum Beispiel als eine Metallisierung dargestellt sein, die eine Goldschicht umfasst, die eine Grundschicht so zum Beispiel eine Unternickelung überdeckt. Die mittels der MID-Technologie erzeugten Metallisierungen sind vorzugsweise in Vertiefungen in die Planfläche der Grundplatte des Sensorgehäuses eingebracht. Bei der MID-Technologie (MID, Molded Interconnect Devices) sind auf dreidimensional geformten spritzgegossenen Schaltungsträgern Leiterbilder in Form einer strukturierten Metallschicht aufgebracht. Im Rahmen der MID-Technologie werden mechanische und elektrische Funktionen im Bauteil zusammengeführt, sowie die Kombination von Gehäuse- und Schaltungsträgerfunktion und die Integration von mechanischen Verbindungs- und Fixierungselementen und Schnapphaken. Dies hat eine erhebliche Reduzierung des Materialeinsatzes sowie der Anzahl der Einzelteile zur Folge. Des Weiteren lässt sich der Montageaufwand für die unterschiedlichen Komponenten erheblich senken und eine Verkürzung der Prozesskette erreichen.

Die einzelnen Vertiefungen für die einzelnen streifenförmigen Metallisierungen sind durch Stege des Kunststoffmaterials der Grundplatte voneinander getrennt. Die Metallisierungen können auch durch Heißeinprägen, Einschallen oder Umspritzung des Kunststoffmaterials in Vertiefungen in Bezug auf die Planfläche der Grundplatte eingelassen sein.

Bevorzugt werden die als Leiterbahn dienenden Metallisierungen derart in Vertiefungen in Bezug auf die obere Planfläche der Grundplatte eingebracht, dass die Vertiefungen eine Breite aufweisen, welche die Streifenbreite der bevorzugt in MID-Technologie ausgeprägten Metallisierungen übersteigt.

Zwischen dem Sensorelement und der als Leiterbahn fungierenden Metallisierung wird eine Bondverbindung ausgeprägt, die einen Bonddraht umfasst. Eine Bondstelle befindet sich auf dem Sensorelement und eine weitere an einem Ende der als Leiterbahn dienenden Metallisierung. Das jeweils andere Ende der als Leiterbahn dienenden Metallisierungen weist eine Bondstelle auf, von der sich ein weiterer Bonddraht zum elektronischen Bauelement beispielsweise zum ASIC erstreckt. Zwischen den beiden Bondstellen an den beiden gegenüberliegenden Enden der als Leiterbahn fungierenden Metallisierungen besteht ein ausreichender Abstand, so dass hier prozesssicher ein Klebematerial, bevorzugt ausgebildet als Kleberaupe, platziert werden kann, welches die Bondstellen, die an den Enden der Leiterbahn dienenden Metallisierungen liegen, nicht berührt. Das Klebematerial in Form einer Kleberaupe kann vor oder nach dem Erzeugen der Bondverbindungen zwischen den Enden der als Leiterbahn dienenden Metallisierung und den Bonddrähten zum elektronischen Bauelement oder zum Sensorelement erzeugt werden.

Das bevorzugt in Form einer Kleberaupe auf die als Leiterbahn dienende Metallisierung aufgebrachte Klebematerial ist derart zwischen den beiden Bondstellen platziert, dass diese sicher nicht berührt werden. Dies führt dazu, dass die Bondstellen mechanisch nicht belastet sind und sich demzufolge ein sehr robuster Aufbau einer elektrischen Verbindung ergibt.

Die erfindungsgemäß vorgeschlagene Lösung trägt dem Umstand Rechnung, dass bei einer Verschlechterung der Verbindung zwischen der als Leiterbahn dienenden Metallisierung und der aus Kunststoffmaterial gefertigten Grundplatte ein Medium eindringen kann und somit eine Abdichtung zwischen Sensorelement auf der einen Seite und dem elektronischen Bauelement, so zum Beispiel einem ASIC, auf der anderen Seite nicht mehr gegeben ist. Diesem Umstand Rechnung tragend ist die als Leiterbahn dienende Metallisierung innerhalb der Vertiefungen in der Grundplatte leicht erhöht angebracht, so dass das Klebematerial, insbesondere aufgebracht als Kleberaupe, zwischen den Enden der als Leiterbahn dienenden Metallisierungen seitlich verschließt und sich auch eine seitliche Abdichtung zwischen den jeweils als Leiterbahn dienenden Metallisierungen und dem Material der Grundplatte ergibt. Zur zusätzlichen Absicherung der Bondstellen an den Enden der als Leiterbahn dienenden Metallisierung sowie der Bonddrähte selbst, kann auf die Medium beaufschlagte Seite der bevorzugt aus Kunststoffmaterial hergestellten Grundplatte ein Gel aufgebracht werden, was sowohl die einzelnen Bonddrähte als auch die Bondstellungen abdeckt.

Das bevorzugt in Form einer Kleberaupe auf die als Leiterbahn dienenden Metallisierungen aufgebrachte Klebematerial ist mediendicht und dichtet darüber hinaus Grundplatte und Deckelplatte beim Fügen gegeneinander ab, so dass kein Medium von der sich beim Fügen von Deckelelement und Grundplatte bildenden Kammer zur Aufnahme des Sensorelementes zur Kammer, in dem das elektronische Bauelement, beispielsweise ein ASIC, überströmt. Die Flexibilität des Klebematerials der Kleberaupe gleicht in besonders vorteilhafter Weise Maß und Einbautoleranzen aus.

Bevorzugt ist an der Unterseite des auf der Grundplatte aufzubringenden Deckelelementes ein Dichtschwert angeordnet, das in bevorzugt als Kleberaupe ausgebildete Anhäufungen von Klebematerial eintaucht und schlussendlich die mediendichte Abdichtung zwischen der Kammer, in der das Sensorelement aufgenommen ist und der Kammer in der das elektronische Bauelement (ASIC) aufgenommen ist, darstellt. Bei der Montage des Deckelelementes fährt das Dichtschwert an der Unterseite des Deckelelementes in das noch weiche und verformbare Material des Klebestoffes ein und verformt diesen, drückt diesen insbesondere in die Freiräume zwischen denen als Leiterbahn dienenden Metallisierungen und den Stegen des Materials der Grundplatte ein, so dass eine mediendichte Abdichtung ausgebildet wird. Die Abmessungen des Dichtschwertes an der Unterseite des Deckelelementes sind bevorzugt so gewählt, dass dieses soweit in die Kleberaupe eindringt, dass eine weitestgehende Verformung des Material des Klebers der Kleberaupe erfolgt und eine Abdichtungen zwischen den beiden Kammern innerhalb des Sensorsgehäuses erreicht werden kann.

Durch die erfindungsgemäß vorgeschlagene Lösung wird eine besonders einfache und kurze elektrische Verbindung zwischen einem Sensorelement und einem elektronischen Bauelement wie zum Beispiel einem ASIC geschaffen. Die einfache und kurze elektrische Verbindung bietet Vorteile hinsichtlich der elektromagnetischen Verträglichkeit, des Platzbedarfes sowie der Kosten. Des Weiteren kann durch die erfindungsgemäß vorgeschlagene Lösung bei mediendichten Verbindungen zwischen elektronischen Bauelementen und dem Sensorelement eine hohe Abgasbeständigkeit des daraus gebildeten gesamten Sensors erreicht werden. Des Weiteren ist in vorteilhafter Weise eine mechanisch robuste Ausführung durch mindestens zwei Bondverbindungen gegeben, die auf eine, eine Leiterbahn darstellende, Metallisierung führen. Die Abdichtung, über die Kleberaupe erfolgt insbesondere außerhalb der Bereiche der Bondstellen, so dass diese mechanisch nicht belastet werden.

### Kurze Beschreibung der Zeichnungen

Anhand der Zeichnungen wird die Erfindung nachstehend eingehender beschrieben.

Es zeigt:
- Figur 1: eine Kleberaupe, welche die als Leiterbahn dienende Metallisierungen zwischen den Bondstellen überdeckt,
- Figur 2: ein die Metallisierung teilweise abdeckendes Gel,
- Figur 3: einen Querschnitt durch die Grundplatte mit Vertiefungen zur Aufnahme der als Leiterbahn dienenden Metallisierungen, wobei die Vertiefung jeweils von Stegen des Materials der Grundplatte voneinander getrennt sind,
- Figur 4: die Darstellung einer Metallisierung in vergrößertem Maßstab,
- Figur 5: eine Komplettdarstellung der Grundplatte und
- Figur 6: das fertig montierte Sensorgehäuse mit einem auf die Grundplatte aufgebrachtes, das Gel sowie die Kleberaupe überdeckendem Deckelelement.

### Ausführungsvarianten

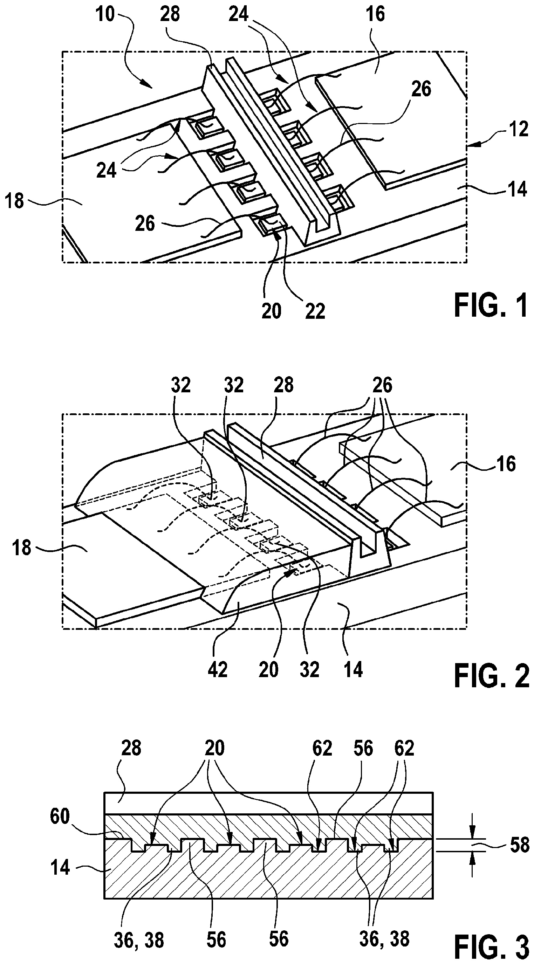

Figur 1 ist eine Grundplatte eines Sensorgehäuses zu entnehmen, welches ein Sensorelement sowie ein elektronisches Bauelement, beispielsweise einen ASIC umfasst.

Bei einem nur schematisch dargestellten Sensor 10 handelt es sich zum Beispiel um eine Niederdrucksensor, wobei auf einer gemeinsamen Grundplatte 14 sowohl ein elektronisches Bauelement 16 beispielsweise ein ASIC als auch ein dem Medium ausgesetztes Sensorelement 18 angeordnet sind. Bevorzugt werden das elektronsiche Bauelement 16 und das Sensorelement 18 auf eine Planfläche 60 der Grundplatte 14 des Sensorgehäuses 12 aufgeklebt. Wie aus der Darstellung gemäß Figur 1 hervorgeht, sind das elektronische Bauelement 16, bei dem es sich beispielsweise um ein ASIC handeln kann, sowie das Sensorelement 18 über einzelne Bonddrähte 26 miteinander verbunden. Die Bonddrähte 24 kontaktieren die einander gegenüberliegende Enden einer Leiterbahn 20 die zum Beispiel durch eine Metallisierung 22 gegeben sein kann. Zwischen den einzelnen Enden der als Leiterbahn 20 dienenden Metallisierungen 22 sowie den Bonddrähten 26 ist ein Abstand ausgebildet, der in der Darstellung gemäß Figur 1 von einer die einzelnen als Leiterbahn 20 fungierenden Metallisierungen 22 mittig übergebenden Kleberaupe 28 überdeckt ist. Die Kleberaupe 28 kann - wie in Figur 1 dargestellt - eine quer zur Längenerstreckung der Grundplatte 14 verlaufende Nut aufweisen, in die, die später noch eingehender beschrieben werden wird, ein Dichtschwert 50 eines Deckelelementes 44 eintauchen.

Aus der Darstellung gemäß Figur 1 geht hervor, dass die Bonddrähte 26 zwischen dem Sensorelement 18 sowie die Bonddrähte 26 zwischen dem elektronischen Bauelement 16 jeweils gegeneinander überliegende Enden der als Leiterbahn 20 fungierenden Metallisierung 22 kontaktieren.

Figur 2 zeigt, dass sowohl die erste Bondstelle 32 an einem Ende der als Leiterbahn dienenden Metallisierungen 22, als auch die Bonddrähte 26, die sich zum Sensorelement 18 erstrecken, von einem Gel 42 überdeckt sein können. Mittels des Gels 42 werden sowohl die Bonddrähte 26 als auch die erste Bondstelle 32 auf der Medium beaufschlagten Seite 40 der Grundplatte 40 gegen das Medium, welches dem des Sensorelement 18 aufgesetzt ist, geschützt.

Bevorzugt wird die Grundplatte 14 des Sensorgehäuses 12 aus einem Kunststoffmaterial so zum Beispiel PPS, Polyphenylensulfid, ein Thermoplast oder PPA, Polyphthalamid, ebenfalls ein Thermoplast, gefertigt. Als Fertigungsverfahren bietet sich insbesondere das Kunststoffspritzgussverfahren an.

Figur 3 zeigt einen Schnitt durch die Grundplatte in dem Bereich des bevorzugt als Kleberaupe aufgebrachten Klebstoffmaterials.

Wie aus Figur 3 hervorgeht, weist die Grundplatte 14 in dem Bereich, der von der Kleberaupe 28 des Klebematerials überdeckt ist, Freiräume 36 auf. Die Freiräume 36 sind voneinander durch Stege 56 des Materials der Grundplatte 14 getrennt. Eine Steghöhe der Materialstege 56 des Materials der Grundplatte 14 ist durch Bezugszeichen 58 gekennzeichnet.

In den einzelnen Freiräumen 36 befinden sich podestartige Vorsprünge auf welchen die als Leiterbahn 20 fungierenden Metallisierungen 22 zum Beispiel aufgebracht werden können. Die als Leiterbahn 20 dienende Metallisierung 22 können zum Beispiel durch Heißeinprägen, Einschallen oder durch Umspritzen des Kunststoffmaterials appliziert werden. Die Metallisierungen 22 werden bevorzugt im Wege der MID-Technik hergestellt und weisen einen Schichtaufbau auf, der an der Oberseite zum Beispiel eine Au-Schicht umfassen kann, die auf eine Nickelschicht aufgebracht ist.

Gemäß den Darstellungen in den Figuren 1 und 2 verläuft die Kleberaupe 28 des Klebstoffmaterials zwischen den Enden der einzelnen als Leiterbahn 20 dienenden Metallisierungen 22.

Beim Aufbringen des Klebematerials in Gestalt einer Kleberaupe 28 verfließt das Material der Kleberaupe 22 in die Freiräume 36, so dass die als Leiterbahn 20 dienenden Metallisierungen 22 auch seitlich d. h. an ihren Flanken, vgl. Position 38, vom Klebematerial der Kleberaupe 28 umschlossen sind und sich demzufolge eine mediendichte Verbindung 62, gebildet durch das fließende Klebstoffmaterial der Kleberaupe 28, einstellt. Dadurch entsteht die Abdichtung zwischen einem Bereich des Sensorgehäuses 12 in dem das Sensorelement 18 aufgenommen ist und dem verbleibenden Bereich des Sensorgehäuses 12 in dem sich das elektronische Bauelement 16, ausgebildet als ASIC, befindet.

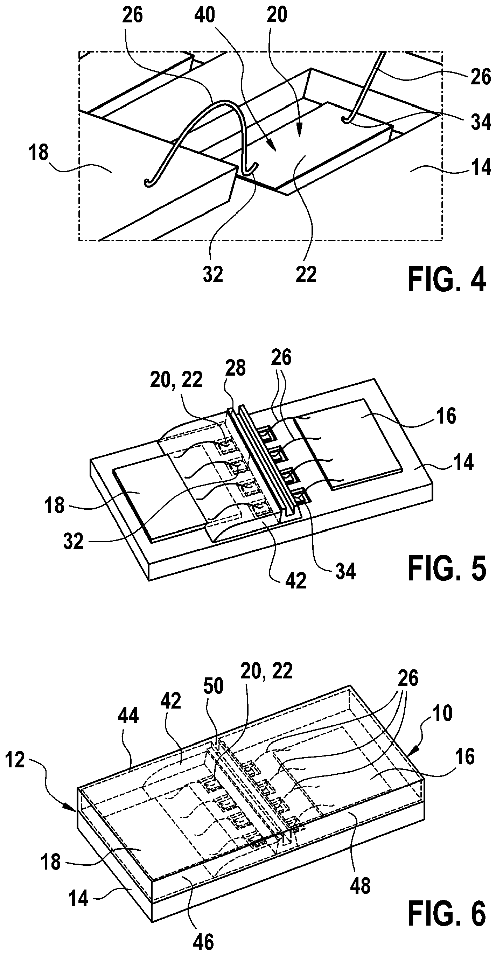

Der Darstellung gemäß Figur 4 ist in vergrößertem Maßstab eine als Leiterbahn dienende Metallisierung zu entnehmen.

Wie aus der Darstellung gemäß Figur 4 hervorgeht, erstreckt sich das vom Medium ausgesetzte Sensorelement 18 der Bonddraht 26 zu einem Ende der als Leiterbahn 20 fungierenden Metallisierung 22, und ist an diesem Ende an einer ersten Bondstelle 32 mit der als Leiterbahn 20 dienenden Metallisierung 22 elektrisch kontaktiert.

Am gegenüberliegenden Ende der als Leiterbahn 20 dienenden Metallisierung 22 liegt eine zweite Bondstelle 34, von der aus sich ein weiterer Bonddraht 26 zum in Figur 4 nicht dargestellten elektronischen Bauelement 16 beispielsweise einem ASIC erstreckt. Aus der Darstellung gemäß Figur 4 geht hervor, dass die Bondstellen 32 beziehungsweise 34 zwischen den Bonddrähten 26 und der als Leiterbahn dienenden Metallisierung 22 soweit auseinander liegen, dass zwischen den Bondstellen 32 und 34 ein ausreichender Platz zur Applikation der Klebraupe 28 verbleibt.

Mit Bezugszeichen 40 ist die dem Medium ausgesetzte Seite der Grundplatte 14 des Sensorgehäuses 12 bezeichnet.

Figur 5 zeigt eine Komplettdarstellung der Grundplatte 14, wobei auf dieser einerseits das elektronische Bauelement 16 und andererseits das Sensorelement 18 aufgenommen sind. Die einzelnen Bonddrähte 26, welche das elektronische Bauelement 16 mit dem Sensorelement 18 verbinden, sind von der Kleberaupe 28 überdeckt, ebenso die Bondstellen 32, 34, die sich auf die Metallisierung 22 der Leiterbahnen 20 befinden, die in Vertiefungen an der Oberseite der Grundplatte 14 eingelassen sind. Mit Bezugszeichen 42 ist ein Gel bezeichnet, welches eine Hälfte der Bonddrähte 26, die sich von den zweiten Bondstellen 32 zum Sensorelement 18 erstrecken, überdeckt.

Figur 6 zeigt das Sensorgehäuse, bei dem das Deckelelement mit der Grundplatte 14 gefügt ist.

Der Darstellung gemäß Figur 6 lässt sich entnehmen, dass im gefügten Zustand eines Deckelelementes 44 mit der Grundplatte 14 ein Dichtschwert 50 in das plastisch verformbare Material der Kleberaupe 28 des Klebematerials eintaucht. Beim Eintauchen des Dichtschwertes an der Unterseite des Deckelelementes 44 wird das Material der Kleberaupe 28 derart verformt, dass dieses in die Freiräume 36, 38, (vgl. Darstellung gemäß Figur 3) verfließt und eindringt und demzufolge unterhalb der Kleberaupe 28 eine mediendichte Verbindung 62 entsteht. Diese mediendichte Verbindung bildet mittig an der Planfläche 60 der Grundplatte 14 eine Kammer 46 in der das Sensorelement 18 aufgenommen ist von einer weiteren Kammer 48 in dem sich das elektronische Bauelement 16, beispielsweise ausgebildet als ASIC, befindet. Wie in Figur 3 dargestellt, wird die mediendichte Verbindung 62 dadurch geschaffen, dass das elastisch verformbare Material bei Eintauchen des Dichtschwerts 50 in die Kleberaupe 28 und die Freiräume 36 neben den als Leiterbahn 20 dienenden Metallisierungen 22 ausfüllt.

Auf diese Weise kann unterhalb der Kleberaupe 28 kein Medium von der Kammer 44, in der das Sensorelement 18 aufgenommen ist, in die Kammer 48 überströmen, in der das elektrische Bauelement 16 angeordnet ist.

Um andererseits die elektrische Verbindung zu schaffen, die robust ist und zudem durch Eindringen des Gels 42 gegen das zu sensierende Medium geschützt werden kann.

Optional können wie in der Darstellung gemäß Figur 6 angedeutet, sowohl die Bonddrähte 26 als auch die ersten Bondstellen 32, die innerhalb der Kammer 46 liegen, in der das Sensorelement 18 aufgenommen ist, von einem Gel 42 geschützt sein. Durch die mediendichte Verbindung 62 gemäß Darstellung in Figur 3 wird das Überströmen des Mediums in die Kammer 48, in der das empfindlichere elektronische Bauelement 16 angeordnet ist, verhindert. Aufgrund der Elastizität des Klebstoffmaterials der Kleberaupe 28, welches sich im Wesentlichen quer zur Längserstreckung der Grundplatte 14 des Sensorgehäuses 12 erstreckt, wird zudem ein Ausgleich von Maß und Einbautoleranzen des Sensorgehäuses 12 des Sensors 10 erreicht. Die Abmessungen des Dichtschwertes 50 an der Unterseite des Deckelelementes 44 sind vorzugsweise derart bemessen, dass dieses soweit in das Klebstoffmaterial der Kleberaupe 28 eindringt, dass ein optimales Verfließen des elastischen verformbaren Klebstoffmaterials der Kleberaupe 28 erreicht wird.

Durch die erfindungsgemäß vorgeschlagene Lösung wie vorstehend anhand der Figuren 1 bis 6 beschrieben, wird eine einfache und kurze elektrische Verbindung 24 zwischen dem Sensorelement 18 und einem elektronischen Bauelement 16 erzielt. Die Kürze der elektrischen Verbindung bietet Vorteile hinsichtlich der elektromagnetischen Verträglichkeit sowie des benötigen Platzbedarfes hinsichtlich der Herstellkosten. Durch die erfindungsgemäß vorgeschlagene Lösung wird eine mediendichte Verbindung 62 innerhalb eines Sensorgehäuses 12 erreicht, was das CiH-Konzept (chip-in-Housing) unterstützt, da während der Herstellung der elektrischen Verbindung eine Abdichtung zwischen der Kammer 46 zur Aufnahme des dem Medium ausgesetzten Sensorelementes 18 einerseits und der Kammer 48, in der das wesentlich empfindlichere elektronsiche Bauelement 16 aufgenommen ist, erreicht werden kann. Damit ist eine erhöhte Abgasbeständigkeit des Sensors 10 gegenüber dem Medium insbesondere dem Abgas gegeben. Die erfindungsgemäß vorgeschlagene Lösung zeichnet sich schließlich durch ihre mechanisch robuste Ausführung durch lediglich zwei Bondverbindungen an den Bondstellen 32 und 34 aus, die auf einer als Leiterbahn 20 dienende Metallisierung 22 geführt sind. Des Weiteren erfolgt die Abdichtung über das Klebstoffmaterial der Kleberaupe 28 außerhalb der Bereiche, an der die Bondstellen 32, 34 liegen, nämlich an den Enden der streifenförmig ausgebildeten Metallisierungen 22, die als Leiterbahn 22 fungieren.

## Patentansprüche

1. Sensor (10) mit einem Sensorgehäuse (12), einem in einer Kammer (46) aufgenommenen Sensorelement (18) und einem in einer weiteren Kammer (48) aufgenommenen elektronischen Bauelement (16), die über mindestens eine elektrische Verbindung (20, 22, 24), welche eine Leiterbahn (20) umfasst, miteinander verbunden sind wobei zwischen der Kammer (46) und der weiteren Kammer (48) eine mediendichte Abdichtung angeordnet ist und wobei zwischen zwei Bondstellen (32, 34) für Bonddrähte (26) der mindestens einen elektrischen Verbindung (20, 22, 24) ein die mediendichte Abdichtung darstellender Kleber (28) platziert ist, **dadurch gekennzeichnet, dass** die zwei Bondstellen (32, 34) an gegenüberliegenden Enden einer als Leiterbahn (20) dienenden Metallisierung (22) angeordnet sind, wobei der Kleber (28) auf die als Leiterbahn (20) dienende Metallisierung (22) platziert ist und wobei der Kleber (28) zwischen der mindestens einen Metallisierung (22) in einer Grundplatte (14) des Sensorgehäuses (12) und einem Deckelelement (44) des Sensorgehäuses (12) eine mediendichte Verbindung (62) bildet und das Deckelelement (44) mit einem Dichtschwert (50) in den Kleber (28) eintaucht, wobei die von der elektrische Verbindung (20, 22, 24) umfasste mindestens eine Metallisierung (22) in MID-Technologie ausgeführt ist und in die Grundplatte (14) des Sensorgehäuses (12) zwischen Stegen (56) des Materials der Grundplatte (14) eingelassen ist und neben der als Leiterbahn (20) dienenden Metallisierung (22) Freiräume (36, 38) ausgebildet sind, die durch die Stege (56) des Materials der Grundplatte (14) getrennt sind und die vom Material des Klebers (28) ausgefüllt sind, wobei das Material des in Gestalt einer Kleberaupe aufgetragenen Klebers (28) in den Freiräumen (36, 38) so verflossen ist, dass die als Leiterbahn (20) dienende Metallisierung (22) auch seitlich an ihren Flanken vom Material des Kleberraupe umschlossen ist.

2. Sensor gemäß Anspruch 1, **dadurch gekennzeichnet, dass** die Metallisierung (22) eine Au-Schicht umfasst und/oder eine Unternickelung aufweist.

3. Sensor gemäß Anspruch 1, **dadurch gekennzeichnet, dass** auf einer Medienseite (40) der Grundplatte (14) ein Gel (42) aufgebracht ist, welches die elektrische Verbindung (20, 22, 24) zumindest teilweise überdeckt.

4. Verfahren zu Herstellung eines Sensors (10) mit einem Sensorgehäuse (12), einem in einer Kammer (46) aufgenommenen Sensorelement (18) und einem in einer weiteren Kammer (48) aufgenommenen elektronischen Bauelement (16), die über mindestens eine elektrische Verbindung (20, 22, 24), welche eine Leiterbahn (20) umfasst, miteinander verbunden sind, mit nachfolgenden Verfahrensschritten:
a) dem Anordnen von zur elektrischen Verbindung gehörenden, als Leiterbahnen (20) dienenden Metallisierungen (22) auf einer Planseite (60) einer Grundplatte (14) des Sensorgehäuses (12),
b) dem Erzeugen von Bondstellen (32, 34) für Bonddrähte (26) an einander gegenüberliegend Enden (52, 54) der als Leiterbahnen (20) dienenden Metallisierung (22),
c) dem Aufbringen eines Klebers (28) auf die als Leiterbahn (20) dienende Metallisierung (22) zwischen den Bondstellen (32, 34) und
d) dem Erzeugen einer mediendichten Abdichtung zwischen den zwei Kammern (46, 48) des Sensorgehäuses (12) durch Verfließen des Klebers (28, 38) in Freiräume (36, 38), die neben der als Leiterbahn (20) dienenden Metallisierung (22) ausgebildet sind und durch Stege (56) des Materials der Grundplatte (14) getrennt sind.

5. Verfahren gemäß Anspruch 4, **dadurch gekennzeichnet, dass** die Metallisierung (22) gemäß Verfahrensschritt a) in MID-Technologie erzeugt wird und bei Eintauchen eines Dichtschwertes (50) eines Deckelelementes (44) in den Kleber (28) eine mediendichte Verbindung (62) zwischen der Grundplatte (14) und dem Deckelelement (44) entsteht.

## Claims

1. Sensor (10) comprising a sensor housing (12), a sensor element (18) which is accommodated in a chamber (46) and an electronic component (16) which is accommodated in a further chamber (48), which sensor element and electronic component are connected to one another by means of at least one electrical connection (20, 22, 24) which comprises a conductor track (20), wherein a media-tight seal is arranged between the chamber (46) and the further chamber (48) and wherein an adhesive (28), which constitutes the media-tight seal, is placed between two bonding points (32, 34) for bonding wires (26) of the at least one electrical connection (20, 22, 24), **characterized in that** the two bonding points (32, 34) are arranged at opposite ends of a metallization (22) which serves as the conductor track (20), wherein the adhesive (28) is placed onto the metallization (22) which serves as the conductor track (20), and wherein the adhesive (28) forms a media-tight connection (62) between the at least one metallization (22) in a base plate (14) of the sensor housing (12) and a cover element (44) of the sensor housing (12), and the cover element (44), by way of a sealing blade (50), dips into the adhesive (28), wherein the at least one metallization (22) which is comprised by the electrical connection (20, 22, 24) is designed using MID technology and is embedded into the base plate (14) of the sensor housing (12) between webs (56) of the material of the base plate (14) and clearances (36, 38) are formed next to the metallization (22) which serves as the conductor track (20), which clearances are separated by the webs (56) of the material of the base plate (14) and are filled by the material of the adhesive (28), wherein the material of the adhesive (28) which is applied in the form of an adhesive bead has flowed into the clearances (36, 38) such that the metallization (22) which serves as the conductor track (20) is also surrounded laterally at its flanks by the material of the adhesive bead.

2. Sensor according to Claim 1, **characterized in that** the metallization (22) comprises a gold layer and/or is underlaid with nickel.

3. Sensor according to Claim 1, **characterized in that** a gel (42) is applied on a media side (40) of the base plate (14), which gel at least partially covers the electrical connection (20, 22, 24).

4. Method for producing a sensor (10) comprising a sensor housing (12), a sensor element (18) which is accommodated in a chamber (46) and an electronic component (16) which is accommodated in a further chamber (48), which sensor element and electronic component are connected to one another by means of at least one electrical connection (20, 22, 24) which comprises a conductor track (20), said method comprising the following method steps:
a) arranging metallizations (22), which form part of the electrical connection and serve as conductor tracks (20), on a flat side (60) of a base plate (14) of the sensor housing (12),
b) producing bonding points (32, 34) for bonding wires (26) at mutually opposite ends (52, 54) of the metallization (22) which serves as a conductor track (20),
c) applying an adhesive (28) onto the metallization (22), which serves as the conductor track (20), between the bonding points (32, 34) and
d) producing a media-tight seal between the two chambers (46, 48) of the sensor housing (12) by virtue of the adhesive (28, 38) flowing into clearances (36, 38) which are formed next to the metallization (22) which serves as the conductor track (20), which clearances are separated by webs (56) of the material of the base plate (14).

5. Method according to Claim 4, **characterized in that** the metallization (22) according to method step a) is produced using MID technology and, when a sealing blade (50) of a cover element (44) dips into the adhesive (28), a media-tight connection (62) is created between the base plate (14) and the cover element (44).

## Revendications

1. Capteur (10) comprenant un boîtier de capteur (12), un élément de capteur (18) logé dans une chambre (46) et un composant électronique (16) logé dans une autre chambre (48), qui sont reliés entre eux par au moins une liaison électrique (20, 22, 24) comprenant une piste conductrice (20), dans lequel un joint étanche aux fluides est disposé entre la chambre (46) et l'autre chambre (48) et dans lequel un adhésif (28) représentant le joint étanche aux fluides est placé entre deux plots de connexion (32, 34) destinés à des fils de connexion (26) de ladite au moins une liaison électrique (20, 22, 24),
**caractérisé en ce que** les deux plots de connexion (32, 34) sont disposés à des extrémités opposées d'une métallisation (22) servant de piste conductrice (20), dans lequel l'adhésif (28) est placé sur la métallisation (22) servant de piste conductrice (20) et dans lequel l'adhésif (28) forme une liaison étanche aux fluides (62) entre ladite au moins une métallisation (22) formée dans une plaque de base (14) du boîtier de capteur (12) et un élément de recouvrement (44) du boîtier de capteur (12), et l'élément de recouvrement (44) est plongé au moyen d'une lame d'étanchéité (50) dans l'adhésif (28), dans lequel ladite au moins une métallisation (22) constituée par la liaison électrique (20, 22, 24) est réalisée en technologie MIO et est incorporée à la plaque de base (14) du boîtier de capteur (12) entre des nervures (56) du matériau de la plaque de base (14), et des espaces libres (36, 38) sont formés à proximité de la métallisation (22) servant de piste conductrice (20) et sont séparés par les nervures (56) du matériau de la plaque de base (14) et remplis par le matériau de l'adhésif (28), dans lequel le matériau de l'adhésif (28) appliqué sous la forme d'un cordon d'adhésif s'est écoulé dans les espaces libres (36, 38) de telle sorte que la métallisation (22) servant de piste conductrice (20) est également entourée latéralement sur ses flancs par le matériau du cordon d'adhésif.

2. Capteur selon la revendication 1, **caractérisé en ce que** la métallisation (22) comprend une couche d'Au et/ou présente une sous-couche de nickel.

3. Capteur selon la revendication 1, **caractérisé en ce qu'**un gel (42), qui recouvre au moins partiellement la liaison électrique (20, 22, 24), est appliqué sur un côté (40) exposé aux fluides de la plaque de base (14).

4. Procédé de fabrication d'un capteur (10) comprenant un boîtier de capteur (12), un élément de capteur (18) logé dans une chambre (46) et un composant électronique (16) logé dans une autre chambre (48), qui sont reliés entre eux par au moins une liaison électrique (20, 22, 24) comprenant une piste conductrice (20), comportant les étapes de procédé suivantes consistant à :
a) disposer des métallisations (22) appartenant à la liaison électrique et servant de pistes conductrices (20) sur une face plane (60) d'une plaque de base (14) du boîtier de capteur (12),
b) réaliser des plots de connexion (32, 34) pour relier des fils de connexion (26) à des extrémités opposées l'une à l'autre (52, 54) de la métallisation (22) servant de pistes conductrices (20),
c) appliquer un adhésif (28) sur la métallisation (22) servant de piste conductrice (20) entre les plots de connexion (32, 34), et
d) réaliser un joint étanche aux fluides entre les deux chambres (46, 48) du boîtier de capteur (12) en faisant en sorte que l'adhésif (28, 38) s'écoule dans des espaces libres (36, 38) qui sont formés à proximité de la métallisation (22) servant de piste conductrice (20) et qui sont séparés par des nervures (56) du matériau de la plaque de base (14).

5. Procédé selon la revendication 4, **caractérisé en ce que** la métallisation (22) selon l'étape de procédé a) est réalisée en technologie MIO et **en ce qu'**une liaison étanche aux fluides (62) est réalisée en plongeant une lame d'étanchéité (50) d'un élément de recouvrement (44) dans l'adhésif (28) entre la plaque de base (14) et l'élément de recouvrement (44).
